# EUROPEAN PATENT APPLICATION

(11) **EP 2 963 823 A1**
(43) Date of publication of application: **06.01.2016**
(21) Application number: 15172310.3
(22) Date of filing: 16.06.2015
(51) Int. Cl.: H03K 17/96

(54) **AUDIO-VISUAL WARNING BUTTON**

(30) Priority: 04.07.2014 TR 201407872
(71) Applicant: Sanel Sanayi Elektronigi imalat ve Ticaret Limited Sirketi, Istanbul (TR)
(72) Inventor: Güller, Eray, Istanbul (TR)
(74) Representative: Dereligil, Ersin

(57) **Abstract**

The invention is related to a button (1) which has a touch interface and gives audio-visual warning after each activation, wherein said button has an electronic circuit (2) placed on a mounting body (6) and LEDs (3) located on the electronic circuit (2) and comprises a touch sensor (5) connected to the electronic circuit (2) and a sound card (4) located on the electronic circuit (2).

## Description

### Technical Field

The invention is related to the buttons which generate the door-opening signal used in public transportation vehicles such as train, bus, minibus, and midibus or the notification signal indicating that a passenger wishes to get off.

The invention is particularly related to a button which has a touch interface for disabled passengers and gives an audio-visual warning after each activation process.

### Prior Art

Today, there exist various buttons with touch-sensing and push-button feature which are used as outside and inside door buttons. Buttons vary in color and size; although they basically have the same function, they differ from each other in giving feedback to the user.

Audio warning and visual warning are not used at the same time in the existing applications. And, it gets harder to notice the warning with the one-feature warning systems. There is not any audio warning in the current touch buttons especially for the visually-challenged users. They do not act as an inclusive button for the disabled.

An application numbered TR 2006/03049 and dated September 21, 2006 has been encountered during the patent search with respect to the touch buttons with warning feature and/or to the audio-visual warning buttons. The invention is an on-off switch-button. Its decorative electronic circuit part gives an aesthetic look. Besides, even though it is in 'on' position in standby state, it will be switched to 'off' position again when triggered. The surrounding light allows for finding the on-off switch when it is dark. The model has a decorative look. It provides ease of use and does not require physical strength. Moreover, it protects the device it activates. Thanks to the mentioned features thereof, it can be used in any place where an on-off switch is needed such as houses, workplaces, plazas and shopping malls, and factories.

A one-feature warning is employed in the invention briefly summarized above as in the prior art. Said invention is not cover all sorts of users.

In conclusion, developments have been made regarding the touch buttons used for warning purposes and new embodiments that will eliminate the abovementioned disadvantages and introduce solutions to the state of the art are needed.

### Description of the Invention

The object of the invention is to provide an embodiment with different technical features offering a novel development in this field based on the embodiments used in the state of the art.

Another object of the invention is to allow for giving warning with flashing light and intermittent sound at the same time instead of the fixed light unlike the current touch buttons.

Another object of the invention is to give audio warning especially for the visually-challenged.

Still another object of the invention is to be used by more users and preferred much more thanks to the fact that it gives both visual and audio warning at the same time.

Another object of the invention is to allow the visually-challenged individuals both to make sure that they pressed the button and to act according to the warning sound.

Yet another object of the invention is to offer a touch sensor made of piezoelectric material.

In order to achieve the abovementioned objects, the invention is related to a button which has a touch interface and gives audio-visual warning after each activation, wherein said button has an electronic circuit placed on a mounting body and LEDs located on the electronic circuit and comprises a touch sensor connected to the electronic circuit and a sound card located on the electronic circuit. The touch sensor is made of piezoelectric material. Besides, LEDs are characterized in having different colors as red LED and green LED.

### Figures to Facilitate Understanding of the Invention

Figure-1 is a disassembled view of the audio-visual warning button of the invention.

### Part Numerals

| | | | |
|---|---|---|---|
| 1- | Button | 5- | Touch sensor |
| 1.1 | Contact surface | 5.1- | Audio output |
| 2- | Electronic circuit | 6- | Mounting body |
| 3- | LED | 6.1- | Space |
| 3.1- | Red LED | 7- | Outer cover |
| 3.2- | Green LED | 8- | Gasket |
| 4- | Sound card | 9- | Connection members |
| | | | |

### Detailed Description of the Invention

The invention is related to a button (1) which has an electronic circuit (2) placed on a mounting body (6) and LEDs (3) located on the electronic circuit (2), characterized in comprising a touch sensor (5) connected to the electronic circuit (2) and a sound card (4) located on the electronic circuit (2).

Figure-1 is a disassembled view of the audio-visual warning button (1) of the invention. The mounting body (6) acts as a carrier and allows the button (1) to be mounted in the place of application. Mounting holes are provided on the mounting body (6). The button is mounted to the place of application through these mounting holes by means of the connection members (9).

The touch sensor (5) is placed to the space (6.1) at the center of the mounting body (6) such that it will be seen and contacted. The touch sensor (5) is made of piezoelectric material. (Figure-1)

An outer cover (7) is used to hide the connection members (9) of the button (1) and to provide a more aesthetic look. (Figure-1)

A gasket (8) is provided under the button (1). It prevents leakage through the connection holes on the mounting surface and reduces vibration. (Figure-1)

The electronic circuit (2) is a circuit on which the electronic materials are arranged. In general, it operates within the range of 10-30V and it is compatible with the EMC norms. The sound card (4) is activated according to the warning signal received from the touch sensor (5) connected to the electronic circuit (2).

As seen in Figure-1, LEDs (3) include red LEDs (3.1) and green LEDs (3.2). There are 13 green LEDs (3.2) and red LEDs (3.1) located at equal intervals on the electronic circuit (2). In so doing, the button (1) is provided with a visual warning feature as red LED (3.1) and green LED (3.2). The number of LEDs (3) can be changed optionally.

The green LEDs (3.2) make the button (1) detectable and they are activated depending on the park entrances. The red LEDs (3.1) on the other hand are lighted up as flashes (flashing lights) when the button (1) is activated.

When the button (1) is activated, it not only warns the user visually by means of the LEDs (3) but also gives out a warning sound by means of the sound card (4). Hence, it allows the visually-challenged individuals to make sure that they pressed the button (1) and also to act according to the installed warning sound. In other words, the touch sensor (5) is triggered as a result of the contact with the contact surface (1.1) of the button (1) and the auditory perception is increased thanks to the sound card (4) according to the warning signals received from the triggered touch sensor (5).

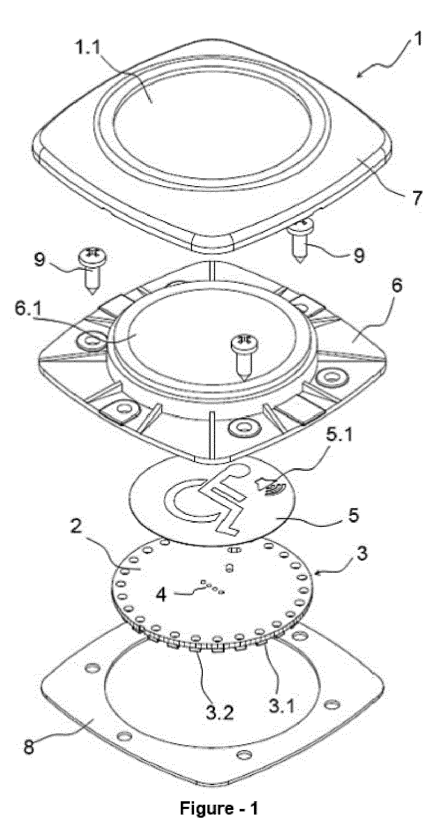

## Claims

1. A button (1) with LEDs (3) and an electronic circuit (2) configured in a mounting body (6), **characterized in** comprising a touch sensor (5) that detects the contact with the contact surface (1.1) of the button (1) and a sound card (4) that offers auditory perception according to the warning signals received from said touch sensor (5).

2. The button as in Claim 1, **characterized in** comprising a piezoelectric sensor (5).

3. The button as in Claim 1, **characterized in that** said LEDs (3) include red LEDs (3.1) and green LEDs (3.2).

4. A button (1) system with LEDs (3) and an electronic circuit (2) configured in a mounting body (6), **characterized in that**
- the touch sensor (5) is triggered as a result of the contact with the contact surface (1.1) of the button (1),
- and the auditory perception is increased thanks to the sound card (4) according to the warning signals received from the triggered touch sensor (5).
